# EUROPEAN PATENT APPLICATION

(11) **EP 2 204 470 A1**
(43) Date of publication of application: **07.07.2010**
(21) Application number: 08172380.1
(22) Date of filing: 19.12.2008
(51) Int. Cl.: C23C 16/04, C23C 14/04

(54) **A method of making a coated cutting tool and a coated cutting tool**

(71) Applicant: Sandvik Intellectual Property AB, 811 81 Sandviken (SE)
(72) Inventor: Myrtveit, Toril, 196 30 Kungsängen (SE); Hessmann, Ingemar, 811 54 Sandviken (SE)
(74) Representative: Hägglöf, Henrik

(57) **Abstract**

The invention relates to a method of making a coated cutting tool comprising a substrate and a coating. The method comprising at least one sequence comprising the following steps:
- masking at least one part of a surface of an uncoated or coated cutting tool body, by applying a layer of an organic compound onto said at least one part,
-deposit a coating onto the cutting tool using a CVD or PVD deposition process, and
-removing the organic compound and the coating from the at least one part.

The invention also relates to cutting tools made according to the present invention.

## Description

### Technical field

The present invention relates to a method of making coated cutting tools which makes it possible to provide different parts of a cutting tool having different coatings or different coating thicknesses by masking selected surfaces during a CVD or PVD process.

### Background

Coated cutting tools like inserts, drills or end mills are traditionally made by depositing coatings by CVD or PVD techniques. However, there is sometimes a requirement to keep parts of the tool uncoated, or to provide different parts of the cutting tool with different coatings.

During all cutting operations it is important to have a tight fit between the tool and the holder. The tolerances of the inserts should be small, both axially and radially, to avoid uneven wear e.g. due to wobbling during cutting operations or to different loads on the inserts in large milling bodies.

The variation in insert thickness can depend on two things, firstly the thickness of the uncoated substrate and secondly on variations in the coating thickness. To minimize tolerances and obtaining the flattest surface possible, some manufacturers choose to grind down inserts either preceding deposition or after deposition, or both. Having uncoated supporting surfaces with better surface contact between insert and seat will also result in better precision in machining, more even wear over the inserts in large milling bodies and better heat conduction from the insert body into the seating surface.

Some inserts are provided with serrations, rails, grooves or other kinds of patterning on the support surface of the insert to secure the insert in the seat. Variation in coating thickness will influence this 3-D patterning. In these cases it is thus even more important to keep tolerances to ensure a tight fit, and in this case grinding cannot easily be performed.

Keeping the supporting surface of the insert uncoated by avoiding deposition on those parts is an option to achieve an uncoated support surface.

Sometimes there is also a need for applying different coatings onto different parts of the tool. For example, it is common to provide the rake and flank faces of an insert with different coatings since different parts of a tool are subjected to different types of wear mechanisms.

Sometimes the problem described above is solved by depositing several layers over the whole cutting tool and then removing some layers from different parts by e.g. brushing or sand blasting.

Another possibility to solve the above mentioned problems is to mask the surfaces that should be kept uncoated during the deposition process and thus avoiding the deposited coating from adhering to part(s) of the tool.

EP0528592A describes a method of selective deposition of CVD diamond coatings. The method comprises first, onto the surfaces that are not to be deposited with the CVD diamond coating, deposit a coating that will soot during CVD deposition e.g. Ni, Co or Fe, and thus no diamond coating will be present on those surfaces. To avoid deposition of the Ni, Co or Fe-layer onto the surfaces that are to be coated with the diamond coating, maskants in the electroplating and electroless plating art can be used, for example photoresists. The maskant is then removed prior to the CVD deposition of the diamond coating.

The temperature during both CVD and PVD deposition is quite high, and most organic compounds will decompose during the deposition process. During deposition, the vacuum and the possible presence of a plasma may strongly influence materials exposed to these conditions.

It is an object of the present invention to provide a method that will make it possible to solve the problems as described above.

It is another object of the present invention to provide a method of making coated cutting tools which provides a convenient way of marking tools e.g. providing logotypes symbols, areas of colored layers etc.

It is another object of the present invention to provide a method of making coated cutting tools giving better tolerances in the work material during machining, e.g. due to smaller tolerances on positioning of the cutting edge.

It has been found that by masking selective surfaces of a cutting tool with a organic compound, either preceding the deposition process or in between deposition steps, the objects above can be fulfilled.

### Description of the invention

The present invention relates to a method of making a coated cutting tool comprising at least one sequence comprising the following steps:
- masking at least one part of a surface of an uncoated or coated cutting tool body, by applying a layer of an organic compound onto said at least one part,
- depositing a coating onto the cutting tool using a CVD or PVD deposition process, and
- removing the organic compound and the deposited coating from the at least one part.

The deposited coating on the areas which have been masked by the organic compound can be more easily removed than the deposited coating on the areas that have not been masked with the organic compound. The coating and the organic compound can either be removed by simply spalling spontaneously, or be removed by a blasting, brushing or grinding process.

In one embodiment of the present invention the organic compound is applied by using a hard mask to cover those areas that should not be provided with a layer of organic compound.

In another embodiment the organic compound is applied by immersing the tool in the organic compound.

The sequence can be performed any number of times, to different parts of the cutting tool and the organic compound can be applied onto uncoated or coated surfaces of the cutting tool.

How the application of the organic compound is performed depends on the geometry of the tool, which areas that are to be coated with the organic compound, the properties of the organic compound e.g. rheological properties, composition etc.

Application of the organic compound is preferably performed by one of the following methods:
- by immersing part of the tool or the whole tool in the organic compound,
- by spraying the organic compound onto the tools. Optionally the tools are rotated or otherwise in motion during the spraying of the organic compound. The tools can also be partly covered with a hard mask during spraying.
- by printing a semi-dry film of the organic compound onto the tool.

The organic compound can be any compound that is resistant enough to the conditions during deposition with respect to e.g. temperatures, vacuum or plasma, i.e. so that it will be present at the surface long enough to prevent the first part of the coating layer from adhering to the underlying surface, being either another coating or the substrate. For example, the organic compound should not evaporate before the deposition of the coating has started. Preferably the organic compound is a polymeric compound.

In one embodiment of the present invention the organic compound is a photoresist. Photoresists are polymeric coatings that are designed to change properties when exposed to light. The photoresists can either be positive i.e. the photoresist on the areas exposed to the UV-light can easily be removed after the exposure, or negative, i.e. the photoresist on the areas exposed to the UV-light is the areas left intact after the exposure.

The use of a photoresist can also comprise steps like drying the photoresist (also called baking), development and stripping etc. If and how these steps are performed is dependent on the specific photoresist used.

The development is usually done by immersing the cutting tool into a liquid which dissolves the photoresist on the areas that are to be coated with a PVD or CVD coating. Which development liquid that is suitable depends on the specific photoresist that is used. Optionally, inhibitors can be added to avoid corrosion of the substrate.

Photoresists can be composed of polymers such as novolac, which are phenol-fomaldehyde type resins. Also other kinds like poly-vinyl cinnamate based or bisazide-based photoresists can be used. For the case when the photoresist is to be used for PVD deposited coatings, an electron photoresist is preferably used since such photoresist can easily tolerate exposure to plasma. Common positive electron photoresists are for instance PMMA (polymethyl methacrylate) and PBA (polybutene-1 sulfone). A common negative electron photoresist is for example COP (polyglycidylmethacrylate-co-ethyl acrylate).

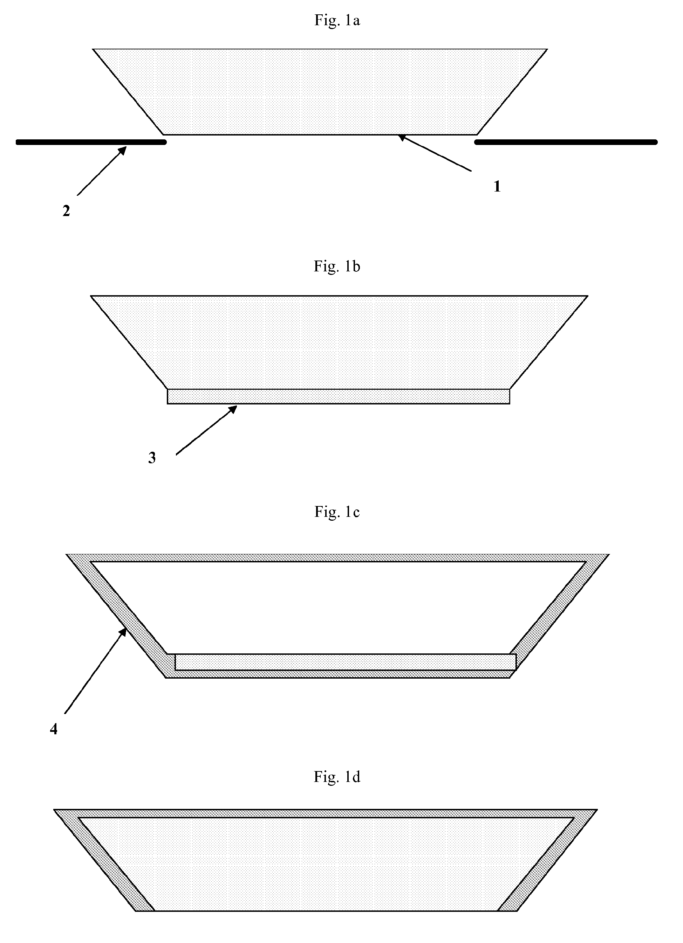

In one embodiment of the present invention, the photoresist can be used without the exposure to UV-light and subsequent development. A hard mask is then used to cover the areas that should not be coated with the photoresist prior to spraying the photoresist onto the tool. The hard mask is preferably a metal plate. The process is schematically illustrated in Figure 1. The photoresist can be either dried in room temperature or at an elevated temperature i.e. it is "baked".

In another embodiment of the present invention, the photoresist is applied with any method mentioned herein, then preferably dried, and then a mask is used to select the areas that should be exposed to the UV-light. By using a mask which only allows the light to pass through in certain areas, the parts that are to be coated with a CVD or PVD coating, can be chosen. Depending on whether the photoresist is negative or positive, the UV-light will either cause the photoresist to polymerize (negative photoresist) or to crack/decompose (positive photoresist) so that it can be removed during development.

In yet another embodiment of the present invention, a semi-dry film of the organic compound is printed on the tool.

The cutting tool comprising areas covered with the organic compound is then rinsed and dried prior to the CVD or PVD deposition step.

In one embodiment of the present invention, the depositing process is a CVD process e.g. conventional CVD or MTCVD.

In another embodiment of the present invention, the depositing process is a PVD process e.g. magnetron sputtering, ion plating, evaporation, cathodic arc evaporation or HIPIMS.

In yet another embodiment of the present invention, the depositing process is a PECVD process or a microwave enhanced deposition process.

In one embodiment of the present invention, the process according to the present invention can be used for imprinting tool information, logotypes or symbols on the tools inactive parts.

The thickness of the PVD or CVD coating, as measured at the thickest part of the coating, can be from 0.5 to 40 µm, preferably from 1 to 20 µm and most preferably from 2 to 15 µm.

The cutting tools are preferably cutting tool inserts, or round tools such as drills, end mills etc.

The coated cutting tool comprises a substrate and a coating. The substrate is preferably made of any of cemented carbide, cermets, ceramics, cubic boron-nitride, poly-crystalline diamond or high speed steels, preferably cemented carbide.

The tools may, after the deposition process, be subjected to any post-deposition process common in the art of cutting tool manufacturing, such as blasting, polishing, brushing, shot peening or grinding.

The present invention also relates to cutting tools made according to the method according to the above.

### Description of drawings

Fig 1a shows a cross-section through a single-sided milling insert (1). A hard mask (2) in the form of a patterned metal plate is aligned with the support face.
Fig 1b shows the same insert after the resist (3) has been applied.
Fig 1c shows the same insert after a PVD- or CVD coating (4) has been deposited.
Fig 1d shows the same insert after the resist and overlying coating material have been removed.
Fig 2 shows a cross-section of a milling insert made according to Example 2.
Fig 3 shows a double-sided insert produced in a similar way as in Figure 1 and 2.

### EXAMPLE 1

Single-sided cemented carbide milling inserts with two different geometries, SBEN and SBEX were used. Insert A (invention) were prior to deposition applied with a patterned steel plate as a hard mask. An opening in the hard mask is situated directly over the support face of the insert with a tight fit. This is shown in Figure 1a. Onto the insert a photoresist is applied. Since the hard mask only is exposing the support face, this is the only surface that is covered with the photoresist. The photoresist was a novolac from CRC Industries called Positiv 20. The inserts were baked at 50°C for 30 min. No exposure to UV light was performed. Insert B (prior art) was only subjected to standard cleaning procedures. Both inserts A and B were coated with a 7 µm thick TiCN-layer and a 7 µm thick alumina layer using conventional CVD deposition technique where chlorides were used as precursors and the deposition temperature was 1000°C. Insert A (invention) spalled spontaneously after deposition on the support face, leaving only a thin rim of coating along the edges. The inserts were after deposition sandblasted on both top and bottom sides. The coating deposited on the masked support face of insert A was completely removed during the sand-blasting process. See figure 1d.

### EXAMPLE 2

Single-sided cemented carbide milling inserts of geometry R290-12 were used. The insert A (invention) an insert B (prior art) were coated with 3 µm TiCN coating using standard MT-CVD technique with chlorides as precursors at a deposition temperature of 900°C. A positive photoresist of type Positiv 20 was applied to insert A, and the inserts were allowed to dry. The inserts were placed with the rake-face up and a mask was carefully aligned to the inserts rake faces. The inserts rake face was subjected to illumination of ultra-violet light for 3 minutes. Insert A was then developed in sodium hydroxide where the exposed parts were removed. Insert A is now covered with a photoresist layer completely covering all flank faces and the support face whereas the rake face is free from resist. Insert A is placed in the CVD-reactor together with insert B, and a second coating is deposited consisting of a 1 µm TiCN layer, and a 3 µm thick alumina layer. After deposition, all inserts were sandblasted, and the coating deposited on the support face and flank faces of insert A was removed. Inserts A and B were subjected to an edge-line brushing to smoothen the coating and even out the differences in coating thickness.

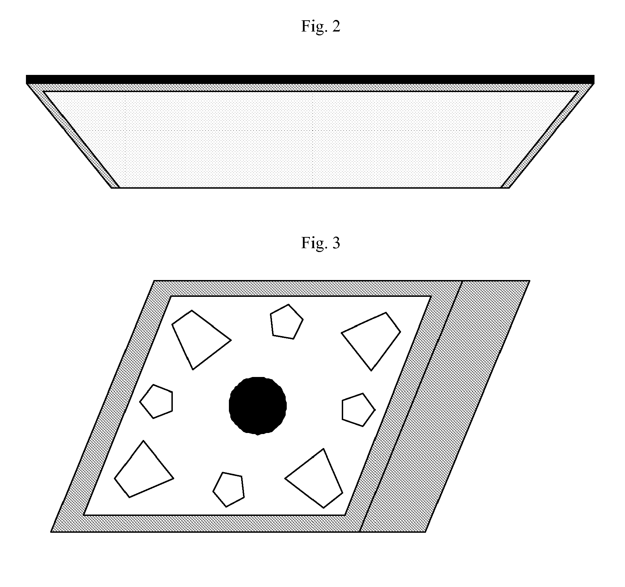

The finished Insert A is thus coated with a TiCN on the flank and support faces, and a TiCN and alumina coating on the rake face. The insert is schematically illustrated in figure 2.

## Claims

1. A method of making a coated cutting tool, comprising at least one sequence comprising the following steps:
- masking at least one part of a surface of an uncoated or coated cutting tool body, by applying a layer of an organic compound onto said at least one part,
- deposit a coating onto the cutting tool using a CVD or PVD deposition process, and
- removing the organic compound and the coating from the at least one part.

2. A method according to claim 1 **characterized in that** the organic compound is applied by using a hard mask to cover those areas that should not be provided with a layer of organic compound.

3. A method according to claim 1 **characterized in that** the organic compound is applied by immersing the tool in the organic compound.

4. A method according to any of the preceding claims **characterized in that** the organic compound is a photoresist.

5. A method according to claim 4 **characterized in that** the photoresist is novolac based.

6. A method according to any of claims 4 or 5 **characterized in that** the cutting tool, after applying the photoresist, is partly covered by a mask and is then subjected to exposure to UV-light.

7. A method according to any of the preceding claims **characterized in that** the cutting tool is coated using a CVD deposition process.

8. A method according to any of the preceding claims **characterized in that** the cutting tool is coated using a PVD deposition process.

9. A method according to claim 8 **characterized in that** the photoresist is a electron photoresist.

10. A coated cutting tool made according to any of claims 1-9.
